# EUROPÄISCHE PATENTANMELDUNG

(11) **EP 4 628 909 A1**
(43) Veröffentlichungstag der Anmeldung: **08.10.2025**
(21) Anmeldenummer: 24168035.4
(22) Anmeldetag: 02.04.2024
(51) Int. Cl.: G01R 31/28, G01R 31/40, G01R 31/42

(54) **VERFAHREN ZUR ÜBERWACHUNG DES ZUSTANDES EINER LEISTUNGSELEKTRONISCHEN VORRICHTUNG, COMPUTERPROGRAMM UND COMPUTERLESBARES MEDIUM**

(71) Anmelder: Siemens Aktiengesellschaft, 80333 München (DE)
(72) Erfinder: Krug, Dietmar, 90425 Nürnberg (DE); Köllensperger, Peter, 90562 Heroldsberg (DE)
(74) Vertreter: Siemens Patent Attorneys

(57) **Zusammenfassung**

Die Erfindung betrifft ein Verfahren zur Überwachung des Zustandes einer leistungselektronischen Vorrichtung (1), insbesondere eines Umrichters, mit zwei oder mehr Komponenten (2-6), von denen wenigstens eine durch ein Halbleiterbauelement (2, 3) gegeben ist,
dadurch gekennzeichnet, dass
- für wenigstens einen Betrachtungszeitpunkt, insbesondere für wenigstens zwei unterschiedliche Betrachtungszeitpunkte, eine Energieeffizienz der leistungselektronischen Vorrichtung (1) ermittelt wird, wobei die Ermittlung der Energieeffizienz für den oder den jeweiligen Betrachtungszeitpunkt auf Basis eines oder mehrerer für die leistungselektronische Vorrichtung (1), insbesondere in und/oder an der leistungselektronischen Vorrichtung (1) und/oder zu dem oder dem jeweiligen Betrachtungszeitpunkt, messtechnisch erfasster Messwerte erfolgt,
- von der für den Betrachtungszeitpunkt ermittelten Energieeffizienz, insbesondere von den für die zwei oder mehr Betrachtungszeitpunkte ermittelten Energieeffizienzen, auf den Zustand, insbesondere auf einen aufgetretenen Alterungsprozess, der leistungselektronischen Vorrichtung (1) geschlossen wird.

Darüber hinaus betrifft die Erfindung ein Computerprogramm und ein computerlesbares Medium.

## Beschreibung

Die Erfindung betrifft ein Verfahren zur Überwachung des Zustandes einer leistungselektronischen Vorrichtung, insbesondere eines Umrichters, mit zwei oder mehr Komponenten, von denen wenigstens eine durch ein Halbleiterbauelement gegeben ist. Darüber hinaus betrifft die Erfindung ein Computerprogramm und ein computerlesbares Medium.

Leistungselektronische Vorrichtungen, bei denen es sich beispielsweise um Umrichter handeln kann, unterliegen verschiedenen Alterungsprozessen, die einen sicheren Betrieb beeinflussen können. Leistungselektronische Vorrichtungen umfassen in der Regel mehrere Komponenten, wobei von den Komponenten eine oder mehrere als Halbleiterbauelement ausgebildet ist bzw. sind. Die in leistungselektronischen Vorrichtungen vorhandenen Halbleiterbauelemente unterliegen einer Alterung durch verschiedene Mechanismen. So treten beispielsweise das sogenannte Bond-Wire Lifting, Alterungen von Lotverbindungen oder auch Direct Copper Bonded Cracks (DCB Cracks) häufig innerhalb von Halbleiterbauelementen auf. Diese Alterungsmechanismen führen zwangsläufig zum Ausfall der Funktionsweise des betroffenen Halbleiterbauelementes bzw. der betroffenen Halbleiterbauelemente und folgend auch der leistungselektronischen Vorrichtung.

Der Anmelderin sind verschiedene Arten des Condition Monitorings von Halbleiterbauelementen bekannt, die auf der direkten Messung von elektrischen bzw. thermischen Größen der Halbleiterbauelemente basieren. Diese haben sich prinzipiell bewährt. Es besteht jedoch weiterhin Bedarf an alternativen Zustandsüberwachungsverfahren.

Es ist eine Aufgabe der vorliegenden Erfindung, ein alternatives Verfahren der eingangs genannten Art anzugeben, das sich vergleichsweise einfach durchführen lässt und eine zuverlässige Zustandsüberwachung ermöglicht.

Diese Aufgabe wird gelöst durch ein Verfahren zur Überwachung des Zustandes einer leistungselektronischen Vorrichtung, insbesondere eines Umrichters, mit zwei oder mehr Komponenten, von denen wenigstens eine durch ein Halbleiterbauelement gegeben ist, dadurch gekennzeichnet, dass
- für wenigstens einen Betrachtungszeitpunkt, insbesondere für wenigstens zwei unterschiedliche Betrachtungszeitpunkte, eine Energieeffizienz der leistungselektronischen Vorrichtung ermittelt wird, wobei die Ermittlung der Energieeffizienz für den oder den jeweiligen Betrachtungszeitpunkt auf Basis eines oder mehrerer für die leistungselektronische Vorrichtung, insbesondere in und/oder an der leistungselektronischen Vorrichtung und/oder zu dem oder dem jeweiligen Betrachtungszeitpunkt, messtechnisch erfasster Messwerte erfolgt, und
- von der für den Betrachtungszeitpunkt ermittelten Energieeffizienz, insbesondere von den für die zwei oder mehr Betrachtungszeitpunkte ermittelten Energieeffizienzen, auf den Zustand, insbesondere auf einen aufgetretenen Alterungsprozess, der leistungselektronischen Vorrichtung geschlossen wird.

Die vorliegende Erfindung basiert mit anderen Worten auf dem Grundgedanken, die Energieeffizienz einer leistungselektronischen Vorrichtung als Ganzes zu bestimmen und für die Zustandsbeurteilung und somit Zustandsüberwachung heranzuziehen. Dabei kann eine Bestimmung der Energieeffizienz in beliebigen Betriebspunkten der leistungselektronischen Vorrichtung erfolgen, die man auch als leistungselektronisches System bezeichnen kann. Wird basierend auf der erfindungsgemäßen Evaluierung der Energieeffizienz der Gesamtvorrichtung an einem oder mehreren Betrachtungszeitpunkten eine alterungsbedingte Veränderung an Komponenten beobachtet angenommen, können geeignete Maßnahmen eingeleitet werden. Beispielsweise kann wenigstens eine Warnung ausgegeben und/oder eine Wartung wenigstens einer Komponente geplant werden.

Eine Ausführungsform des erfindungsgemäßen Verfahrens zeichnet sich dadurch aus, dass für den Fall, dass die oder wenigstens eine ermittelte Energieeffizienz unterhalb eines vorgegebenen Schwellwertes liegt, darauf geschlossen wird, dass die leistungselektronische Vorrichtung gealtert ist, insbesondere einen alterungsbedingten Defekt aufweist. Es kann insbesondere darauf geschlossen werden, dass wenigstens eine Komponente der leistungselektronischen Vorrichtung, bevorzugt wenigstens ein Halbleiterbauelement dieser, gealtert ist. Der vorgegebene Schwellwert kann beispielsweise durch Berechnung hergeleitet und/oder zuvor durch Messungen bestimmt worden sein.

Es sei angemerkt, dass alternativ oder zusätzlich zu einer festen Differenzschwelle beispielweise auch die erste Ableitung der Differenz über mehrere Zeitpunkte eine mögliche Auswertegröße darstellen kann.

Die leistungselektronische Vorrichtung umfasst mehrere Komponenten, von denen eine oder mehrere durch Halbleiterbauelemente gegeben sind. Rein beispielhaft für Halbleiterbauelemente, von denen die überwachte leistungselektronische Vorrichtung eines oder mehrere umfassen kann, seien IBGTs (Insulated Gate Bipolar Transistoren) und/oder MOSFETs (MetallOxid-Halbleiter-Feldeffekttransistoren) und/oder Dioden genannt. Die leistungselektronische Vorrichtung wird neben einem oder mehreren Halbleiterbauelementen in der Regel noch weitere Komponenten umfassen. Beispielhaft für weitere Komponenten leistungselektronischer Vorrichtungen seien wenigstens ein Kondensator, wenigstens ein Lüfter und wenigstens eine Steuerung genannt.

Für die Ermittlung der Gesamtenergieeffizienz zu dem einen oder den verschiedenen Betrachtungszeitpunkten werden erfindungsgemäß einer oder mehrere Messwerte der leistungselektronischen Vorrichtung herangezogen. Es sei angemerkt, dass die messtechnische Erfassung der Messwerte Bestandteil des erfindungsgemäßen Verfahrens sein kann, jedoch nicht sein muss. Es kann beispielsweise auch auf vorhandene Messwerte zugegriffen werden, die vor der Durchführung des erfindungsgemäßen Verfahrens erfasst wurden, insbesondere Messwerte, die ohnehin bereits für einen anderen Zweck zur Verfügung stehen und an einem beliebigen Ort gespeichert sind. Für die Erfassung der Messwerte können Messeinrichtungen, etwa Sensoren, zum Einsatz kommen bzw. gekommen sein, die in den leistungselektronischen Vorrichtungen ohnehin standardmäßig vorhanden sind. Mit der Durchführung des erfindungsgemäßen Verfahrens muss entsprechend kein zusätzlicher konstruktiver Aufwand der leistungselektronischen Vorrichtung einhergehen.

Der oder die Messwerte sind messtechnisch erfasste Werte wenigstens einer physikalischen Größe, etwa wenigstens einer elektrischen Größe und/oder wenigstens einer thermischen Größe der leistungselektronischen Vorrichtung. Es handelt sich insbesondere um einen oder mehrere Messwerte einer oder mehrerer physikalischer Größen, welche die leistungselektronische Vorrichtung als Ganzes, mit anderen Worten die leistungselektronische Gesamtvorrichtung, betrifft bzw. betreffen. Es kann sich z. B. um Strom- und/oder Spannungs- und/oder Temperaturmesswerte der leistungselektronischen Vorrichtung handeln, die an und/oder in der leistungselektronischen Vorrichtung erfasst werden bzw. erfasst wurden. Es kann prinzipiell ausreichend sein, wenn für die Ermittlung der Energieeffizienzen an dem oder den verschiedenen Betrachtungszeitpunkten jeweils nur ein Messwert einer physikalischen Größe herangezogen wird. Es ist aber natürlich auch möglich, für die Ermittlung einer Energieeffizienz an einem Betrachtungszeitpunkt Messwerte von mehr als einer physikalischen Messgröße heranzuziehen, etwa jeweils einen Strommesswert und einen Spannungsmesswerte.

Die Ermittlung der Energieeffizienz für den oder die Betrachtungszeitpunkte kann insbesondere erfolgen, indem eine die bzw. die jeweilige Energieeffizienz repräsentierende Größe bestimmt, etwa berechnet, wird. Rein beispielhaft für eine die Energieeffizienz einer leistungselektronischen Vorrichtung zu einem bestimmten Zeitpunkt repräsentierende Größe sei die Verlustleistung der leistungselektronischen Vorrichtung zu dem Zeitpunkt genannt. Eine alterungsbedingte Änderung, insbesondere Zunahme der Verlustleistung mit der Zeit entspricht einer alterungsbedingten Abnahme bzw. repräsentiert eine alterungsbedingte Abnahme der Energieeffizienz. Eine die Energieeffizienz repräsentierende Größe kann beispielsweise auch durch eine Temperaturdifferenz gegeben sein, etwa die Differenz zwischen der Temperatur der Zu- und Abluft einer luftgekühlten leistungselektronischen Vorrichtung oder die Differenz der Zulauf- und Ablauftemperatur eines flüssigen Kühlmediums für die Kühlung der leistungselektronischen Vorrichtung.

Die Alterung des bzw. der Halbleiterbauelemente der leistungselektronischen Vorrichtung führt in der Regel zu einer veränderten, insbesondere höheren Verlustleistung und Temperatur in der Gesamtvorrichtung, mit anderen Worten im Gesamtsystem. Die veränderte, insbesondere höhere Verlustleistung kann beispielsweise durch einen erhöhten Innenwiderstand in einem Modul bzw. einer Komponente (z. B. durch Wegfall von Bond-Verbindungen) oder durch einen Betrieb der Halbleiter bei höheren Temperaturen (z. B. durch höhere thermische Widerstände aufgrund von Lotschädigung) entstehen.

Das erfindungsgemäße Verfahren hat sich als ganz besonders geeignet für die Zustandsüberwachung von Umrichtern erwiesen. Es kann beispielsweise wenigstens ein AC/DC Umrichter und/oder wenigstens ein DC/DC Umrichter und/oder wenigstens ein DC/AC Umrichter und/oder wenigsten ein AC/AC Umrichter überwacht werden. Es kann aber auch für andere Arten leistungselektronischer Vorrichtungen zum Einsatz kommen. Rein beispielhaft seien halbleiterbasierte Leistungsschalter ("solid state circuit breakers") genannt.

Während es prinzipiell ausreichend ist, wenn die Energieeffizienz für einen Betrachtungszeitpunkt ermittelt und für die Zustandsbeurteilung herangezogen wird, hat es sich als vorteilhaft erwiesen, auf mehr als einen Betrachtungszeitpunkt abzustellen. So kann vorgesehen sein, dass die Energieeffizienz für wenigstens zwei Betrachtungszeitpunkte ermittelt wird und die zu den verschiedenen Betrachtungszeitpunkten gehörigen Energieeffizienzen miteinander verglichen werden, und anhand des Vergleichs der Energieeffizienzen auf den Zustand, insbesondere auf einen aufgetretenen Alterungsprozess, der leistungselektronischen Vorrichtung geschlossen wird.

Wird auf zwei unterschiedliche Zeitpunkte abgestellt, wird eine Veränderung mit der Zeit beobachtbar. Die unterschiedlichen Betrachtungszeitpunkte sind voneinander verschiedene, zeitlich voneinander beabstandete Zeitpunkte.

Es ist natürlich möglich und je nach Anwendungsfall zweckmäßig, wenn die Energieeffizienz für mehr als zwei Betrachtungszeitpunkte ermittelt wird. Dies kann z. B. auch wiederholt während des Betriebes der leistungselektronischen Vorrichtung erfolgen, etwa stündlich, täglich, wöchentlich oder monatlich oder mit anderen, beliebigen Zeitabständen. Auch unregelmäßige Abstände sind möglich. Es ist auch eine Beobachtung bzw. Überwachung der Energieeffizienz über den Lebenszyklus der leistungselektronischen Vorrichtung möglich.

Wird auf mehr als zwei Betrachtungszeitpunkte abgestellt, werden bevorzugt (jeweils) zumindest die Energieeffizienzen unmittelbar aufeinanderfolgender Betrachtungszeitpunkte verglichen. Dies insbesondere, um einen Rückschluss auf den Zustand bzw. eine Zustandsänderung der Vorrichtung ziehen zu können.

Der Vergleich der Energieeffizienzen zweier Betrachtungszeitpunkte kann beispielsweise einschließen oder dadurch erfolgen, dass die Differenz zwischen den Energieeffizienzen der zwei oder im Falle mehrerer zweier Betrachtungszeitpunkte gebildet wird.

Für den Fall, dass der Vergleich der zu den - zwei oder mehr - verschiedenen Betrachtungszeitpunkten gehörigen Energieeffizienzen ergibt, dass die Energieeffizienz an einem zweiten, späteren Betrachtungszeitpunkt niedriger ist oder war als an einem ersten, früheren Betrachtungszeitpunkt, wird in vorteilhafter Ausgestaltung darauf geschlossen, dass die leistungselektronische Vorrichtung gealtert ist, insbesondere einen alterungsbedingten Effekt, etwa Defekt aufweist. Es kann insbesondere darauf geschlossen werden, dass wenigstens eine Komponente der leistungselektronischen Vorrichtung, bevorzugt wenigstens ein Halbleiterbauelement dieser, gealtert ist.

Dabei kann darauf abgestellt werden, dass die Energieeffizienz an dem zweiten, späteren Betrachtungszeitpunkt um einen vorgegebenen Schwellwert niedriger ist oder war als an dem ersten, früheren Betrachtungszeitpunkt.

Es kann vorgesehen sein, dass aufgrund der Annahme einer alterungsbedingten Zustandsänderung, insbesondere aufgrund der Annahme eines alterungsbedingten Defektes, der leistungselektronischen Vorrichtung wenigstens eine Komponente dieser gewartet oder ausgetauscht oder eine Wartung oder ein Austausch geplant werden. Hierdurch können ungeplante Ausfälle vermieden und ein sicherer Betrieb mit einer besonders hohen Zuverlässigkeit gewährleistet werden.

Bevorzugt gilt, dass die zu den verschiedenen Betrachtungszeitpunkten gehörigen Energieeffizienzen gleiche Betriebspunkte der leistungselektronischen Vorrichtung betreffen. In diesem Falle weisen die Energieeffizienzen keinerlei Abweichungen aufgrund verschiedener Betriebspunkte auf und sind direkt miteinander vergleichbar. Es ist aber auch nicht zwingend erforderlich, dass gleiche Betriebspunkte betrachtet werden. Sind sie nicht gleich, kann beispielsweise eine Anpassung bzw. Auswertung mit Hilfe wenigstens eines geeigneten Algorithmus, der zweckmäßigerweise auf Eigenschaften der Komponenten basiert, erfolgen.

Die Erfassung der Messwerte, anhand derer die Energieeffizienzen für die verschiedenen Betrachtungszeitpunkte ermittelt werden, erfolgt bzw. erfolgte in zweckmäßiger Weise bei gleichen Betriebspunkten bzw. für gleiche Betriebspunkte.

Weiterhinkann gelten, dass die leistungselektronische Vorrichtung zu den verschiedenen Betrachtungszeitpunkten verschieden lange Betriebsdauern absolviert hat. Auch kann vorgesehen sein, dass einer der Betrachtungszeitpunkte vor der ersten Inbetriebnahme der leistungselektronischen Vorrichtung liegt.

Als ganz besonders geeignet hat sich erwiesen, wenn für den Fall, dass Energieeffizienzen für mehr als einen Betrachtungszeitpunkt ermittelt werden, einer der Betrachtungszeitpunkte, konkret der erste Betrachtungszeitpunkt, einen nicht gealterten Zustand der leistungselektronischen Vorrichtung betrifft. Dann wird mit anderen Worten die Energieeffizienz initial für den nicht gealterten Zustand der leistungselektronischen Vorrichtung ermittelt, mit dem dann verglichen werden kann. Beispielsweise kann der erste Betrachtungszeitpunkt (nahe) am Ende eines Produktionsvorganges der leistungselektronischen Vorrichtung liegen. Bevorzugt gilt, dass ein erster Betrachtungszeitpunkt um eine produktspezifische, definierte Dauer nach dem Abschluss eines Produktionsvorganges der leistungselektronischen Vorrichtung liegt.

Ausgehend von der initialen Energieeffizienz, durch welche sich die leistungselektronische Vorrichtung im nicht gealterten Zustand auszeichnet, können besonders geeignet Änderungen über die Zeit, insbesondere den Betriebszyklus, beobachtet werden.

Ausgehend von der initialen Energieeffizienz können beobachtete Änderungen auch besonders gut, etwa mit wenigstens einem geeigneten Algorithmus, qualifiziert werden, um der Änderung bzw. den Änderungen wenigstens einen physikalischen Alterungsprozess zuordnen zu können. Dies kann dann auch bei einer Identifizierung der von dem oder den Alterungsprozessen betroffenen Komponente(n) helfen.

Eine besonders vorteilhafte Ausführungsform des erfindungsgemäßen Verfahrens zeichnet sich dadurch aus, dass ermittelt wird, welche Komponente oder welche Komponenten der leistungselektronischen Vorrichtung von der Alterung betroffen ist bzw. sind. Hierfür kann beispielsweise wenigstens ein geeigneter Algorithmus genutzt werden.

Alternativ oder zusätzlich ist es möglich, hierfür wenigstens einen Komponenten-Temperaturmesswert wenigstens einer Komponente der leistungselektronischen Vorrichtung heranzuziehen. Rein beispielhaft sei genannt, dass, nachdem der Vergleich der Energieeffizienzen von wenigstens zwei Betrachtungszeitpunkten ergeben hat, dass diese mit der Zeit schlechter wurde und ein alterungsbedingter Effekt, insbesondere alterungsbedingter Defekt, angenommen wird, Temperaturmesswerte von einer oder mehreren Komponenten der leistungselektronischen Vorrichtung erfasst bzw. betrachtet bzw. herangezogen werden. In der Regel weisen leistungselektronische Vorrichtungen standardmäßig Sensoren auf, mittels derer die Temperatur einzelner Komponenten im Betrieb erfasst wird. Komponenten-Temperaturmesswerte liegen daher in der Regel ohnehin vor, so dass kein zusätzlicher Aufwand entsteht. Kommt dann z. B. heraus, dass eine oder mehrere Komponenten, insbesondere eines oder mehrere Halbleiterbauelemente, eine erhöhte Temperatur aufweist bzw. aufgewiesen haben, wird bevorzugt davon ausgegangen, dass diese Komponente oder diese Komponenten einen alterungsbedingten Effekt, insbesondere Defekt aufweisen. Betroffene Komponenten können im Vergleich zu weiteren, nicht betroffenen Komponenten z. B. eine geänderte, insbesondere erhöhte, Verlustleistung und damit Temperatur aufweisen.

Alternativ oder zusätzlich ist es möglich, dass hierfür ein Analysebetrieb der leistungselektronischen Vorrichtung absolviert wird. Dies zweckmäßigerweise nach der Zustandsbeurteilung, insbesondere nach der Feststellung bzw. Annahme, dass ein alterungsbedingter Effekt, insbesondere Defekt, der leistungselektronischen Vorrichtung vorliegt. Im Rahmen des Analysebetriebes wird zweckmäßigerweise wenigstens ein Betriebsparameter wenigstens einer Komponente der leistungselektronischen Vorrichtung gezielt geändert, um zu ermitteln, ob diese wenigstens eine Komponente der leistungselektronischen Vorrichtung von der Alterung betroffen ist, insbesondere einem die Energieeffizienz beeinflussenden Alterungsprozess unterlegen hat. Durch zusätzliche Test- bzw. Betriebsszenarien kann eine genauere Zuordnung einer von Alterung betroffenen Komponente erfolgen oder auch ausgeschlossen werden. Rein beispielhaft sei genannt, dass die Schaltfrequenz einer als Halbleiterbauelement ausgebildeten Komponente der leistungselektronischen Vorrichtung bei erkannter Energieeffizienzabweichung gezielt verändert wird. Durch das Anheben bzw. Absenken der Schaltfrequenz kann die Verlustleistung in dem betreffenden Bauelement erhöht bzw. verringert werden. Ist diese Änderung, verglichen mit den Änderungen an weiteren Bauelementen, außerhalb eines Toleranzbandes, so kann auf einen alterungsbedingten Defekt geschlossen werden. Die maximal erlaubte Änderung der Verlustleistung kann durch Berechnung im Betrieb oder während der Inbetriebsetzung bestimmt werden. Alternativ oder zusätzlich können auch weitere Betriebsparameter verändert werden: z. B. Zwischenkreisspannung und/oder Ausgangströme und/oder Ausgangsspannungen und/oder Eingangsspannungen und/oder Eingangsströme und/oder die Phasenverschiebung zwischen Strom und Spannung.

Auch ist es möglich, dass anhand des Vergleichs der Energieeffizienzen darauf geschlossen wird, welche Art von Alterungsprozess aufgetreten ist. Beispielsweise kann wenigstens ein geeigneter Algorithmus genutzt werden, um die Änderung der Energieeffizienz zwischen zwei Betrachtungszeitpunkten zu qualifizieren und einem bestimmten physikalischen Alterungsprozess zuzuordnen. Dann kann in Verbindung mit der Art des Alterungsprozesses darauf geschlossen werden, welche Komponente oder Komponenten der leistungselektronischen Vorrichtung von der Alterung betroffen ist oder sind.

Basierend auf dem erfindungsgemäßen Vergleich der Energieeffizienzen wenigstens zweier Betrachtungszeitpunkte kann auch eine Vorhersage erfolgen, wann ein Ausfall des leistungselektronischen Systems auftreten wird. Diese Vorhersage kann für eine Wartungsplanung und/oder einen Austauschzeitpunkt herangezogen werden.

Für die Ermittlung der zu dem oder dem jeweiligen Betrachtungszeitpunkt gehörigen Energieeffizienzen kann insbesondere die Eingangsleistung der leistungselektronischen Vorrichtung zu dem oder dem jeweiligen Betrachtungszeitpunkt herangezogen werden. Die Eingangsleistung kann aus dem Eingangsstrom und der Eingangsspannung der leistungselektronischen Vorrichtung gebildet sein bzw. werden.

Alternativ oder zusätzlich kann für die Ermittlung der zu dem oder dem jeweiligen Betrachtungszeitpunkt gehörigen Energieeffizienzen die Ausgangsleistung der leistungselektronischen Vorrichtung zu dem oder dem jeweiligen Betrachtungszeitpunkt, insbesondere gebildet aus Ausgangsstrom und Ausgangsspannung, herangezogen werden. Für den Fall, dass die leistungselektronische Vorrichtung zwei oder mehr Ausgänge aufweist, kann auf die Summe der Ausgangsleitungen der zwei oder mehr Ausgänge abgestellt werden.

Wiederum alternativ oder zusätzlich kann hierfür die Zwischenkreisleitung der leistungselektronischen Vorrichtung zu dem oder dem jeweiligen Betrachtungszeitpunkt, insbesondere gebildet aus Zwischenkreisstrom und Zwischenkreisspannung, herangezogen werden.

Insbesondere durch die Bildung der Differenzen zwischen diesen Leistungen kann die Energieeffizienz für einen, zwei oder mehr Betrachtungszeitpunkte ermittelt werden.

Bevorzugt gilt, dass eine Eingangs- und eine Ausgangsleistung herangezogen werden. Alternativ oder zusätzlich können auch eine Eingangs- und eine Zwischenkreisleistung herangezogen werden. Wiederum alternativ oder zusätzlich können eine Zwischenkreis- und eine Ausgangsleistung herangezogen werden. Die Differenz der Leistungen, z. B. der Eingangsleistung Pein und Ausgangsleistung Paus, ist ein Verlustleistung Pv bzw. kann als solche herangezogen bzw. betrachtet werden, also z. B. Pein - Paus = Pv. Als Energieeffizienz kann beispielsweise die Ausgansleitung dividiert durch die Summe aus Ausgansleistung und Verlustleistung berechnet werden, also Energieeffizienz = Paus/(Paus+Pv).

Der oder die Messwerte, anhand derer die (jeweilige) Energieeffizienz ermittelt wird, können dementsprechend durch den Eingangsstrom und/oder die Eingangsspannung der leistungselektronischen Vorrichtung insbesondere zu dem jeweiligen Betrachtungszeitpunkt, und/oder den Ausgangsstrom und/oder die Ausgangsspannung der leistungselektronischen Vorrichtung insbesondere zu dem jeweiligen Betrachtungszeitpunkt, und/oder den Zwischenkreisstrom und/oder die Zwischenkreisspannung der leistungselektronischen Vorrichtung insbesondere zu dem jeweiligen Betrachtungszeitpunkt gegeben sein oder diese umfassen.

Auch ist es möglich, dass von den Messwerten die Eingangsleistung der leistungselektronischen Vorrichtung zu dem (jeweiligen) Betrachtungszeitpunkt, und/oder die Ausgangsleistung der leistungselektronischen Vorrichtung zu dem (jeweiligen) Betrachtungszeitpunkt, und/oder die Zwischenkreisleistung der leistungselektronischen Vorrichtung zu dem (jeweiligen) Betrachtungszeitpunkt abgeleitet, insbesondere berechnet wird. Beispielsweise können der Eingangsstrom und die Eingangsspannung eines Betrachtungszeitpunktes als Messwerte erfasst bzw. bereitgestellt bzw. herangezogen und aus diesen die Eingangsleistung berechnet werden. In analoger Weise kann die Ausgangsleistung für den oder die Betrachtungszeitpunkte aus dem jeweiligen Ausgangsstrom und der Ausgangsspannung berechnet werden und/oder die Zwischenkreisleistung aus Zwischenkreisstrom und Zwischenkreisspannung. Die aus den Messwerten erhaltene Eingangsleistung und/oder Ausgangsleistung und/oder Zwischenkreisleistung für den (jeweiligen) Betrachtungszeitpunkt können dann ihrerseits herangezogen werden, um die Energieeffizienzen zu erhalten, insbesondere zu berechnen.

Wie angemerkt, können auch thermische Größen bzw. Messwerte für die Energieeffizienzermittlung genutzt werden.

Beispielsweise kann vorgesehen sein, dass die leistungselektronische Vorrichtung mittels eines Kühlfluids gekühlt wird. In diesem Falle können die Messwerte, anhand derer die Energieeffizienzen für den oder die Betrachtungszeitpunkte ermittelt werden, durch Temperaturmesswerte des Kühlfluids gegeben sein, die an jeweils zwei voneinander verschiedenen, in und/oder vor und/oder nach der leistungselektronischen Vorrichtung liegenden Messstellen messtechnisch erfasst werden oder wurden. Bevorzugt wird in diesem Falle die Differenz zwischen den Temperaturmesswerten an den zwei verschiedenen Temperatur-Messstellen berechnet und für die Ermittlung der Energieeffizienz(en) herangezogen. Eine Änderung einer solchen Temperaturdifferenz mit der Zeit weist auf eine veränderte, insbesondere erhöhte Verlustleistung und somit eine geringere Energieeffizienz hin. Es sei angemerkt, dass für die Bestimmung der Verlustleistung zweckmäßigerweise die Durchflussmenge bzw. der Volumenstrom berücksichtigt werden. Diese könnte man z. B. als konstant annehmen oder messen oder berechnen.

Beispielhaft sei genannt, dass die Temperatur eines Kühlfluids am oder unmittelbar vor Eintritt in die leistungselektronische Vorrichtung und am oder unmittelbar nach Austritt aus der leistungselektronischen Vorrichtung erfasst wird bzw. wurde und diese Temperaturmesswerte herangezogen werden.

Bei dem Kühlfluid kann es sich beispielsweise um Luft handeln und die Temperaturmesswerte, anhand derer die Energieeffizienz(en) für den oder die Betrachtungszeitpunkte ermittelt werden, können durch Temperaturmesswerte der Zuluft und der Abluft gegeben sein.

Natürlich ist es auch möglich, dass das Kühlfluid flüssig ist und die Temperaturmesswerte, anhand derer die Energieeffizienz(en) ermittelt werden, durch Zulauf- und Rücklauftemperaturmesswerte des flüssigen Kühlfluids gegeben sind.

Alternativ oder zusätzlich kann auch wenigstens eine Temperatur herangezogen werden, die mittels eines Modulsensors oder modulnahen Temperatursensors der leistungselektronischen Vorrichtung erfasst wurde. Als Modulsensor ist dabei ein Temperatursensor zu verstehen, der in einem Halbleitermodul/-gehäuse in der Nähe der Leistungshalbleiter (z. B. IGBT) platziert ist. Ein modulnaher Temperatursensor liegt nahe eines Halbleitermodul(gehäuse)s. Beispielsweise kann dann über die Höhe der Differenz zwischen der Temperatur des Modulsensors bzw. modulnahen Sensors und der Zuluft- bzw. Zulauftemperatur in einem bestimmten Betriebspunkt auf eine erhöhte Verlustleistung in dem Halbleiter (welcher im Modul sitzt) im Vergleich zu einem nicht durch Alterung beanspruchten Modul geschlossen werden.

Es hat sich auch als zweckmäßig erwiesen, wenn an dem oder - im Falle mehrerer - dem jeweiligen Betrachtungszeitpunkt auftretende oder aufgetretene Verluste, insbesondere Verlustleistungen, der leistungselektronischen Vorrichtung ermittelt werden. Eine Änderung, etwa Zunahme von Verlusten, etwa ein Anstieg der Verlustleistung der Vorrichtung, kann als Indikator für eine Änderung, insbesondere Abnahme der Energieeffizienz angesehen werden. In Weiterbildung können daher zu dem oder dem jeweiligen Betrachtungszeitpunkt gehörige Verluste, insbesondere Verlustleistungen, für die Ermittlung der Energieeffizienz(en) herangezogen oder als die Energieeffizienz(en) repräsentierende Größe(n) betrachtet werden. Man kann auch sagen, über die an dem oder den Betrachtungszeitpunkten auftretenden bzw. aufgetretenen Verluste, insbesondere Verlustleistungen, wird die (jeweilige) Energieeffizienz ermittelt, etwa aus den Messgrößen berechnet.

Oftmals kommen Anordnungen mit nicht nur einer, sondern mehreren, insbesondere seriell oder parallel verschalteten, leistungselektronischen Vorrichtungen, wie Umrichtern, zum Einsatz. Es versteht sich, dass es in diesem Falle sowohl möglich ist, beispielhaft nur eine der leistungselektronischen Vorrichtungen, etwa einen der Umrichter, auf die erfindungsgemäße Weise zu überwachen. Alternativ können aber natürlich auch einige, etwa zwei oder mehr, oder auch alle leistungselektronischen Vorrichtungen, wie Umrichter, einer oder mehrere Anordnungen auf die erfindungsgemäße Weise überwacht werden. Mit anderen Worten kann das erfindungsgemäße Verfahren für zwei oder mehr leistungselektronische Vorrichtungen durchgeführt werden, die Bestandteilt einer Anordnung und/oder seriell oder parallel miteinander verschaltet sind.

Ein weiterer Gegenstand der vorliegenden Erfindung ist ein Computerprogramm, das Programmcodemittel umfasst, die, wenn sie auf wenigstens einem Computer ausgeführt werden, den wenigstens einen Computer veranlassen, die Schritte des erfindungsgemäßen Verfahrens durchzuführen. Das Computerprogramm kann auf wenigstens einem beliebigen Rechner laufen und/oder unter Nutzung einer Cloud. Es ist auch möglich, dass die zu überwachende leistungselektronische Vorrichtung wenigstens einen Speicher umfasst, in dem das erfindungsgemäße Computerprogramm abgelegt ist, und wenigstens einen Prozessor, mittels dem dieses ausgeführt wird. Die Überwachung kann dann mit anderen Worten durch die Vorrichtung selbst bzw. direkt auf dieser absolviert werden.

Die Erfindung betrifft auch ein computerlesbares Medium, das Instruktionen umfasst, die, wenn sie auf wenigstens einem Computer ausgeführt werden, den wenigstens einen Computer veranlassen, die Schritte des erfindungsgemäßen Verfahrens durchzuführen. Bei dem computerlesbaren Medium kann es sich beispielsweise um eine CD-ROM oder DVD oder einen USB oder Flash Speicher handeln. Es sei angemerkt, dass unter einem computerlesbaren Medium nicht ausschließlich ein körperliches Medium zu verstehen sein soll, sondern ein solches beispielswiese auch in Form eines Datenstromes und/oder eines Signals, welches einen Datenstrom repräsentiert, vorliegen kann.

Für die weitere Ausgestaltung der Erfindung wird auf die Unteransprüche und die Beschreibung des nachfolgenden Ausführungsbeispiels unter Bezugnahme auf die Zeichnung verwiesen. In der Zeichnung zeigt:
- FIG 1: eine als Umrichter ausgebildete leistungselektronische Vorrichtung in rein schematischer Darstellung,
- FIG 2: n Umrichter gemäß FIG 1 in Reihenschaltung, von denen in FIG 2 beispielhaft zwei Umrichter gezeigt sind, und
- FIG 3: n Umrichter gemäß FIG 1 in Parallelschaltung, von denen in FIG 2 beispielhaft zwei Umrichter gezeigt sind.

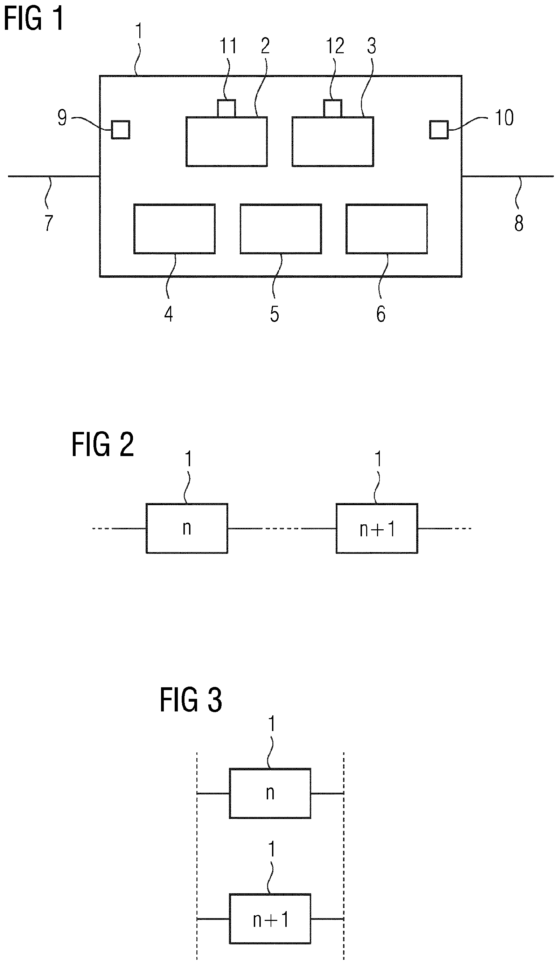

Die FIG 1 zeigt in stark vereinfachter, rein schematischer Darstellung eine leistungselektronische Vorrichtung, die vorliegend beispielhaft als Umrichter 1 ausgebildet ist. Es kann sich um einen AC/DC Umrichter, einen DC/DC Umrichter, einen DC/AC Umrichter oder auch einen AC/AC Umrichter handeln.

Der Umrichter 1 umfasst eine Mehrzahl von Komponenten, wobei eine oder mehrere der Komponenten durch Halbleiterbauelemente gegeben sind. In der FIG 1 sind beispielhaft zwei Halbleiterbauelemente 2, 3, ein Kondensator 4, ein Lüfter 5 und eine Steuerung 6 des Umrichters 1 schematisch dargestellt. Es versteht sich, dass die Anzahl der Komponenten innerhalb eines Umrichters 1 prinzipiell beliebig sein kann. Es sind ferner zwei Anschlüsse 7, 8 des Umrichters 1 gezeigt. Es versteht sich, dass dieser beliebig viele weitere Anschlüsse, etwa für Mehrphasenszenarien, Zwischenkreisverbindungen und/oder ausgelagerte Komponenten, wie beispielsweise Bremswiderstände, aufweisen kann. In FIG 1 sind die Anschlüsse nur stark vereinfacht dargestellt. Auch ist in der rein schematischen FIG 1 die weitere innere Struktur einschließlich interner Leitungen des Umrichters 1 aus Gründen der Übersichtlichkeit nicht gezeigt.

Der in FIG 1 dargestellte Umrichter 1 weist eine in der FIG nicht weiter dargestellte Kühlluftführung, insbesondere einen oder mehrere zugehörige Kanäle auf. Die Förderung der Kühlluft durch den bzw. die Kanäle ist mittels des Lüfters 5 realisiert. Alternativ oder zusätzlich kann auch eine Kühlung des Umrichters 1 mit einem flüssigen Kühlmedium, etwa Wasser, erfolgen, wobei der Umrichter 1 dann einen zugehörigen Kühlkreislauf aufweist (nicht dargestellt).

Bei den dargestellten Halbleiterbauelementen handelt es sich vorliegend um einen IGBT 2 und einen MOSFET 3, wobei auch dies, einschließlich deren Anzahl, rein beispielhaft zu verstehen ist. Zum Beispiel kann alternativ oder zusätzlich auch wenigstens eine als Diode ausgebildetes Halbleiterbauelementen und/oder eines oder mehrere Halbleiterbauelemente anderer Art vorhanden sein.

Die Halbleiterbauelemente 2, 3 unterliegen einer Alterung durch verschiedene Mechanismen. So treten beispielsweise das sogenannte Bond-Wire Lifting, Alterungen von Lotverbindungen oder auch Direct Copper Bondend Cracks (DCB Cracks) häufig innerhalb von Halbleiterbauelementen 2, 3 auf. Diese Alterungsmechanismen führen zwangsläufig zum Ausfall der Funktionsweise der betroffenen Halbleiterbauelemente 2, 3 und folgend auch der leistungselektronischen Vorrichtung 1.

Es ist durchaus möglich, dass mehrere leistungselektronische Systeme, wie der in FIG 1 dargestellte Umrichter 1, zum Einsatz kommen können, die seriell oder parallel verschaltet sind. Dies ist beispielhaft in den schematischen FIG 2 und 3 gezeigt, von denen die FIG 3 n Umrichter 1 gemäß FIG 1 zeigt, die seriell verschaltet sind, und die FIG 3 n Umrichter 1 gemäß FIG 1, die parallel verschaltet sind. Die vereinfachten, schematischen FIG 2 und 3 zeigen dabei beispielhaft jeweils nur zwei Umrichter 1, die in den FIG mit n bzw. n+1 versehen sind. Es versteht sich, dass auch eine Anordnung aus mehr als zwei leistungselektronische Systeme, etwa Umrichtern 1 gemäß FIG 1, die seriell oder parallel verschaltet sind, vorgesehen sein bzw. zum Einsatz kommen kann. So können beispielsweise auch drei, vier, fünf, sechs, sieben oder mehr leistungselektronische Systeme, etwa Umrichter 1, vorhanden sein.

Mit dem im Folgenden beschriebenen Ausführungsbeispiel des erfindungsgemäßen Verfahrens kann eine zuverlässige Zustandsüberwachung des Umrichters 1 erfolgen. Es versteht sich, dass für den Fall, dass zwei oder mehr Umrichter 1 vorhanden sind (vgl. FIG 2 und 3), natürlich auch zwei oder mehr, bevorzugt alle vorhandenen Umrichter 1 auf die im Folgenden beschriebene Weise überwacht werden können. Im Folgenden wird dabei beispielhaft die Überwachung eines Umrichter 1 beschrieben. Die Schritte können dabei von einem Ausführungsbeispiel eines erfindungsgemäßen Computerprogramms ausgeführt werden.

Dabei wird für mehrere zeitlich unterschiedliche Betrachtungszeitpunkte eine Energieeffizienz des Umrichters 1 ermittelt, wobei die Ermittlung der Energieeffizienzen die verschiedenen Betrachtungszeitpunkte auf Basis eines oder mehrerer für den Umrichter 1 messtechnisch erfasster Messwerte erfolgt.

Zur Bestimmung der Energieeffizienz bzw. Verlustleistung einer leistungselektronischen Vorrichtung 1 zu dem jeweiligen Betrachtungszeitpunkt können im Rahmen des vorliegenden Verfahrens insbesondere folgende physikalischen Größen herangezogen werden.

Elektrische Größen:
- Eingangsleistung des Umrichters 1 gebildet aus Eingangsstrom und -spannung
- Ausgangsleistung des Umrichters 1 gebildet aus Ausgangsstrom und -spannung
- Zwischenkreisleistung des Umrichters 1 gebildet aus Zwischenkreisstrom und -spannung

Thermische Größen:
- Temperatur der Zuluft und der Abluft des Umrichters 1;
- Temperatur des Zulaufes eines zur Kühlung des Umrichters 1 zum Einsatz kommenden flüssigen Kühlmediums und dessen Rücklauftemperatur
- Temperatur eines Modulsensors bzw. modulnahen Sensors des Umrichters 1

Diese Größen können Messwerte darstellen, die in und/oder an dem Umrichter 1 zu dem jeweiligen Betrachtungszeitpunkt erfasst werden bzw. erfasst wurden oder sie können von solchen Messwerten abgeleitet werden, um dann wiederum für die Energieeffizienz- bzw. Verlustleistungsermittlung genutzt zu werden.

Es sei angemerkt, dass die messtechnische Erfassung einer oder mehrerer der vorgenannten Größen Bestandteil des erfindungsgemäßen Verfahrens sein kann, jedoch nicht sein muss. Es kann beispielsweise auch auf vorhandene, in der Vergangenheit erfasste und abgespeicherte Messwerte zugegriffen werden. Für die Erfassung der Messwerte können Messeinrichtungen, etwa Sensoren zum Einsatz kommen bzw. gekommen sein, die in dem Umrichter 1 ohnehin standardmäßig vorhanden sind. Mit der Durchführung des erfindungsgemäßen Verfahrens geht somit kein zusätzlicher konstruktiver Aufwand des Umrichters 1 einher.

Bei dem hier beschriebenen Beispiel werden als Messwerte für die Energieeffizienzbestimmung Temperaturwerte der Kühlluft, konkret die Temperatur der Zuluft und der Abluft des Umrichters 1 genutzt. Der Umrichter 1 weist zwei Temperatursensoren 9, 10 auf, welche die Zu- und Ablufttemperaturen messen können. Aus den Zu- und Ablufttemperaturmesswerten des jeweiligen Betrachtungszeitpunktes wird die Differenz a ermittelt, konkret berechnet.

Zweckmäßigerweise werden auch die Durchflussmenge bzw. der Volumenstrom berücksichtigt. Diese können als konstant angenommen oder gemessen oder berechnet werden.

Eine Änderung der Differenz zwischen Ab- und Zuluft über die Zeit weist auf einen Anstieg der Verlustleistung und entspricht bzw. repräsentiert somit einer Abnahme der Energieeffizienz des Umrichters 1.

Es kann alternativ oder zusätzlich die Verlustleistung aus der Differenz aus den aus- und eingangsseitigen Leistungen berechnet werden. Für die Berechnung der ein- und ausgangsseitigen Leistungen werden die entsprechenden ein- und ausgangsseitigen Strom- und Spannungsgrößen messtechnisch erfasst. Für einen AC-Eingang bzw. -Ausgang kann zweckmäßigerweise der Winkel der Grundschwingung zwischen Strom und Spannung berücksichtigt werden, wenn Wirkleistungsberechnungen erfolgen.

Bei dem vorliegenden Beispiel wird die Energieeffizienz - konkret die Verlustleistung als die Energieeffizienz repräsentierende Größe - einerseits für einen Betrachtungszeitpunkt ermittelt, zu dem der Umrichter 1 bzw. dessen Komponenten einschließlich der Halbleiterbauelemente 2, 3 noch keiner Alterung unterlagen. Dieser erste Betrachtungszeitpunkt lag beispielhaft unmittelbar im Anschluss an den Abschluss des Herstellungsvorganges des Umrichters 1 und noch vor dessen Inbetriebnahme am eigentlichen Verwendungsort. Man kann auch sagen, die Energieeffizienz wird einerseits für den nicht gealterten Zustand des Umrichters 1 aufgenommen. Hierfür kann der Umrichter 1 direkt im Anschluss an die Herstellung in einem Testbetrieb betrieben werden bzw. worden sein, um Messwerte für Zu- und Abluft zu erhalten. Im laufenden, realen Betrieb des Umrichters 1 am eigentlichen Verwendungsort wird dann wenigstens ein weiteres Mal, bevorzugt mehrfach, basierend auf den Messwerten für Zu- und Ablufttemperatur die Temperaturdifferenz als die Energieeffizienz zum jeweiligen Betrachtungszeitpunkt ermittelt. Es kann wiederholt über den Lebenszyklus des Umrichters 1 erfolgen, wie im Bereich der Zustandsüberwachung prinzipiell vorbekannt. Die zu den mehreren Betrachtungszeitpunkten gehörigen ermittelten Energieeffizienzen betreffen dabei zweckmäßigerweise gleiche Betriebspunkte des Umrichters 1, so dass eine direkte Vergleichbarkeit gewährleistet ist.

Von der für die Betrachtungszeitpunkte ermittelten Energieeffizienzen wird auf den Zustand, insbesondere auf einen aufgetretenen Alterungsprozess, des Umrichters 1 geschlossen.

Die in dem bzw. für den laufenden Betrieb ermittelten Energieeffizienzen können beispielsweise jeweils mit der initialen Energieeffizienz des Umrichters 1 im nicht gealterten Zustand verglichen werden, was sich als besonders zweckmäßig erwiesen hat. Es wird z. B. jeweils die Differenz gebildet und für den Fall, dass die Differenz einen vorgegebenen Schwellwert überschreitet, darauf geschlossen, dass der Umrichter 1 gealtert ist, insbesondere einen alterungsbedingten Defekt aufweist.

Alternativ oder zusätzlich zu einer festen Differenzschwelle kann beispielweise auch die erste Ableitung der Differenz über mehrere Zeitpunkte eine mögliche Auswertegröße darstellen kann.

Wird aufgrund einer Änderung, konkret Abnahme der Energieeffizienz um mehr als einen vorgegebenen Wert auf das Bestehen eines alterungsbedingten Defektes geschlossen, wird bevorzugterweise anschließend ermittelt, welche Komponente oder Komponenten 2-6 des Umrichters 1 von einer Alterung betroffen ist oder sind. Beispielsweise kann mit wenigstens einem geeigneten Algorithmus die bzw. die jeweilige Effizienzänderung qualifiziert werden, um dieser wenigstens einen physikalischen Alterungsprozess zuordnen zu können. Dies kann dann bei einer Identifizierung der von dem oder den Alterungsprozessen betroffenen Komponente(n) 2-6 helfen.

Auch kann wenigstens ein Komponenten-Temperaturmesswert wenigstens einer Komponente 2-6 des Umrichters 1 herangezogen werden. In der Regel weisen leistungselektronische Vorrichtungen interne und/oder in der unmittelbaren Nähe befindliche Temperatursensoren auf, mittels derer die Temperatur einzelner Komponenten 2-6 im Betrieb ohnehin überwacht wird. Bei dem in FIG 1 dargestellten Ausführungsbeispiel sind Temperatursensoren 11, 12 zur Messung der Temperatur der Halbleiterbauelemente 2, 3 vorhanden. Auf von diesen erfassten Messwerten kann somit zugegriffen werden. Zeigt sich z. B., dass ein Halbleiterbauelement eine - insbesondere im Vergleich zu wenigstens einem weiteren Halbleiterbauelement - erhöhte Temperatur aufweist bzw. aufgewiesen hat, wird davon ausgegangen, dass (zumindest) dieses Halbleiterbauelement einen alterungsbedingten Defekt aufweist. Dies kann z. B. für den MOSFET 3 der Fall sein.

Alternativ oder zusätzlich ist es auch möglich, insbesondere für die Identifikation gealterter Komponenten 2-6 einen Analysebetrieb des Umrichters 1 zu absolvieren. Z. B. wird wenigstens ein Betriebsparameter wenigstens einer Komponente 2-6 gezielt geändert, um zu ermitteln, ob diese wenigstens eine Komponente 2-6 einem die Energieeffizienz des Umrichters 1 beeinflussenden Alterungsprozess unterlegen ist. Beispielsweise kann die Schaltfrequenz des MOSFETs 3 angehoben werden.

Aufgrund der Annahme des alterungsbedingten Defektes kann wenigstens ein Halbleiterbauelement, z. B. der MOSFET 3, gewartet oder ausgetauscht werden bzw. es kann eine Wartung oder ein Austausch dieses geplant werden. Im Ergebnis wird ein besonders zuverlässiger und gleichzeitig effizienter Betrieb des Umrichters 1 gewährleistet.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Unabhängig vom grammatikalischen Geschlecht eines bestimmten Begriffes sind Personen mit männlicher, weiblicher oder anderer Geschlechteridentität mit umfasst.

### Bezugszeichenliste

- 1: Umrichter
- 2: IGBT
- 3: MOSFET
- 4: Kondensator
- 5: Lüfter
- 6: Steuerung
- 7: Anschluss
- 8: Anschluss
- 9: Temperatursensor
- 10: Temperatursensor
- 11: Temperatursensor
- 12: Temperatursensor

## Patentansprüche

1. Verfahren zur Überwachung des Zustandes einer leistungselektronischen Vorrichtung (1), insbesondere eines Umrichters, mit zwei oder mehr Komponenten (2-6), von denen wenigstens eine durch ein Halbleiterbauelement (2, 3) gegeben ist,
**dadurch gekennzeichnet, dass**
- für wenigstens einen Betrachtungszeitpunkt, insbesondere für wenigstens zwei unterschiedliche Betrachtungszeitpunkte, eine Energieeffizienz der leistungselektronischen Vorrichtung (1) ermittelt wird, wobei die Ermittlung der Energieeffizienz für den oder den jeweiligen Betrachtungszeitpunkt auf Basis eines oder mehrerer für die leistungselektronische Vorrichtung (1), insbesondere in und/oder an der leistungselektronischen Vorrichtung (1) und/oder zu dem oder dem jeweiligen Betrachtungszeitpunkt, messtechnisch erfasster Messwerte erfolgt,
- von der für den Betrachtungszeitpunkt ermittelten Energieeffizienz, insbesondere von den für die zwei oder mehr Betrachtungszeitpunkte ermittelten Energieeffizienzen, auf den Zustand, insbesondere auf einen aufgetretenen Alterungsprozess, der leistungselektronischen Vorrichtung (1) geschlossen wird.

2. Verfahren nach Anspruch 1, **dadurch gekennzeichnet, dass** für den Fall, dass die oder wenigstens eine ermittelte Energieeffizienz unterhalb eines vorgegebenen Schwellwertes liegt, darauf geschlossen wird, dass die leistungselektronische Vorrichtung (1) gealtert ist, insbesondere einen alterungsbedingten Defekt aufweist.

3. Verfahren nach Anspruch 1 oder 2, **dadurch gekennzeichnet, dass** die Energieeffizienz für wenigstens zwei Betrachtungszeitpunkte ermittelt wird und die zu den verschiedenen Betrachtungszeitpunkten gehörigen Energieeffizienzen miteinander verglichen werden, und anhand des Vergleichs der Energieeffizienzen auf den Zustand, insbesondere auf einen aufgetretenen Alterungsprozess, der leistungselektronischen Vorrichtung (1) geschlossen wird, bevorzugt, wobei anhand des Vergleichs der Energieeffizienzen darauf geschlossen wird, welche Art von Alterungsprozess aufgetreten ist, bevorzugt, wobei von der Art des Alterungsprozesses darauf geschlossen wird, welche Komponente (2-6) oder Komponenten (2-6) der leistungselektronischen Vorrichtung (1) von der Alterung betroffen ist oder sind.

4. Verfahren nach Anspruch 3, **dadurch gekennzeichnet, dass** für den Fall, dass der Vergleich, der zu den verschiedenen Betrachtungszeitpunkten gehörigen Energieeffizienzen ergibt, dass die Energieeffizienz an einem zweiten, späteren Betrachtungszeitpunkt insbesondere um einen vorgegebenen Schwellwert niedriger ist oder war als an einem ersten, früheren Betrachtungszeitpunkt, darauf geschlossen wird, dass die leistungselektronische Vorrichtung (1) gealtert ist, insbesondere einen alterungsbedingten Defekt aufweist.

5. Verfahren nach Anspruch 3 oder 4, **dadurch gekennzeichnet, dass** die zu dem oder dem jeweiligen Betrachtungszeitpunkte gehörige ermittelte Energieeffizienz gleiche Betriebspunkte der leistungselektronischen Vorrichtung (1) betreffen, und/oder dass die Erfassung der Messwerte, anhand derer die Energieeffizienzen für die verschiedenen Betrachtungszeitpunkte ermittelt werden, bei gleichen Betriebspunkten erfolgt oder erfolgte.

6. Verfahren nach einem der Ansprüche 3 bis 5, **dadurch gekennzeichnet, dass** die leistungselektronische Vorrichtung (1) zu den verschiedenen Betrachtungszeitpunkten verschieden lange Betriebsdauern absolviert hat, und/oder dass einer der Betrachtungszeitpunkte vor der ersten Inbetriebnahme der leistungselektronischen Vorrichtung (1) liegt.

7. Verfahren nach einem der vorhergehenden Ansprüche, **dadurch gekennzeichn et**, dass ermittelt wird, welche Komponente (2-6) oder Komponenten (2-6) der leistungselektronischen Vorrichtung (1) von einer Alterung betroffen ist oder sind, bevorzugt, wobei hierfür wenigstens ein Algorithmus genutzt wird, und/oder, wobei hierfür wenigstens ein Komponenten-Temperaturmesswert wenigstens einer Komponente (2-6) der leistungselektronischen Vorrichtung (1) herangezogen wird, und/oder wobei hierfür ein Analysebetrieb der leistungselektronischen Vorrichtung (1) absolviert wird, wobei im Rahmen des Analysebetriebes wenigstens ein Betriebsparameter wenigstens einer Komponente (2-6) der leistungselektronischen Vorrichtung (1) gezielt geändert wird, um zu ermitteln, ob diese wenigstens eine Komponente (2-6) der leistungselektronischen Vorrichtung (1) von der Alterung betroffen ist, insbesondere einem die Energieeffizienz der leistungselektronischen Vorrichtung beeinflussenden Alterungsprozess unterlegen hat.

8. Verfahren nach einem der vorhergehenden Ansprüche, **dadurch gekennzeichn et,** dass aufgrund der Annahme einer alterungsbedingten Zustandsänderung, insbesondere aufgrund der Annahme eines alterungsbedingten Defektes wenigstens eine Komponente (2-6) der leistungselektronischen Vorrichtung (1) gewartet oder ausgetauscht oder eine Wartung oder ein Austausch geplant werden.

9. Verfahren nach einem der vorhergehenden Ansprüche, **dadurch gekennzeichn et**, dass von den Messwerten die Eingangsleistung der leistungselektronischen Vorrichtung (1) zu dem oder dem jeweiligen Betrachtungszeitpunkt, und/oder die Ausgangsleistung der leistungselektronischen Vorrichtung (1) zu dem oder dem jeweiligen Betrachtungszeitpunkt, und/oder die Zwischenkreisleitung der leistungselektronischen Vorrichtung (1) zu dem oder dem jeweiligen Betrachtungszeitpunkt abgeleitet wird.

10. Verfahren nach einem der vorhergehenden Ansprüche, **dadurch gekennzeich net**, dass für die Ermittlung der zu dem oder dem jeweiligen Betrachtungszeitpunkt gehörigen Energieeffizienz die Eingangsleistung der leistungselektronischen Vorrichtung (1) zu dem oder jeweiligen Betrachtungszeitpunkt, insbesondere gebildet aus Eingangsstrom und Eingangsspannung, und/oder die Ausgangsleistung der leistungselektronischen Vorrichtung (1) zu dem oder dem jeweiligen Betrachtungszeitpunkt, insbesondere gebildet aus Ausgangsstrom und Ausgangsspannung, und/oder die Zwischenkreisleitung der leistungselektronischen Vorrichtung (1) zu dem oder dem jeweiligen Betrachtungszeitpunkt, insbesondere gebildet aus Zwischenkreisstrom und Zwischenkreisspannung, herangezogen werden.

11. Verfahren nach Anspruch 10, **dadurch gekennzeichnet, dass** die Messwerte, anhand derer die Energieeffizienz für den oder den jeweiligen Betrachtungszeitpunkt ermittelt wird, den Eingangsstrom und/oder die Eingangsspannung der leistungselektronischen Vorrichtung (1) insbesondere zu dem oder dem jeweiligen Betrachtungszeitpunkt, und/oder den Ausgangsstrom und/oder die Ausgangsspannung der leistungselektronischen Vorrichtung (1) insbesondere zu dem oder dem jeweiligen Betrachtungszeitpunkt, und/oder den Zwischenkreisstrom und/oder die Zwischenkreisspannung der leistungselektronischen Vorrichtung (1) insbesondere zu dem oder dem jeweiligen Betrachtungszeitpunkt umfassen oder dadurch gegeben sind.

12. Verfahren nach einem der vorhergehenden Ansprüche, **dadurch gekennzeichn et**, dass die leistungselektronische Vorrichtung (1) mittels eines Kühlfluids gekühlt wird, bevorzugt, wobei die Messwerte, anhand derer die Energieeffizienz für den oder den jeweiligen Betrachtungszeitpunkt ermittelt wird, durch Temperaturmesswerte des Kühlfluids gegeben sind, die an jeweils zwei verschiedenen, in und/oder vor und/oder nach der leistungselektronischen Vorrichtung (1) liegenden Messstellen messtechnisch erfasst werden oder wurden, bevorzugt, wobei jeweils die Differenz zwischen den Temperaturmesswerten an den zwei verschiedenen Messstellen berechnet und für die Ermittlung der Energieeffizienz für den oder den jeweiligen Betrachtungszeitpunkt herangezogen wird.

13. Verfahren nach Anspruch 12, **dadurch gekennzeichnet, dass** es sich bei dem Kühlfluid um Luft handelt und die Temperaturmesswerte, anhand derer die Energieeffizienz für den oder den jeweiligen Betrachtungszeitpunkt ermittelt wird, durch Temperaturmesswerte der Zuluft und der Abluft gegeben sind, oder das Kühlfluid flüssig ist und die Temperaturmesswerte, anhand derer die Energieeffizienz für den oder den jeweiligen Betrachtungszeitpunkt ermittelt wird, durch Zulauf- und Rücklauftemperaturmesswerte des flüssigen Kühlfluids gegeben sind.

14. Verfahren nach einem der vorhergehenden Ansprüche, **dadurch gekennzeichn et,** dass an dem oder dem jeweiligen Betrachtungszeitpunkt auftretende oder aufgetretene Verluste, insbesondere Verlustleistungen, der leistungselektronischen Vorrichtung ermittelt werden, insbesondere, wobei die Verluste, insbesondere Verlustleistungen, für die Ermittlung der Energieeffizienz für den oder den jeweiligen Betrachtungszeitpunkt herangezogen oder als die Energieeffizienz für den oder den jeweiligen Betrachtungszeitpunkt repräsentierende Größen betrachtet werden.

15. Computerprogramm, umfassend Befehle, die, wenn sie auf wenigstens einem Computer ausgeführt werden, den wenigstens einen Computer veranlassen, die Schritte des Verfahrens nach einem der Ansprüche 1 bis 14 durchzuführen.

16. Computerlesbares Medium, umfassend Befehle, die, wenn sie auf wenigstens einem Computer ausgeführt werden, den wenigstens einen Computer veranlassen, die Schritte des Verfahrens nach einem der Ansprüche 1 bis 14 durchzuführen.
